# EUROPÄISCHE PATENTSCHRIFT

(11) **EP 0 987 816 B1**
(45) Veröffentlichungstag und Bekanntmachung des Hinweises auf die Patenterteilung: **20.11.2002**
(21) Anmeldenummer: 99117770.0
(22) Anmeldetag: 09.09.1999
(51) Int. Cl.: H02M 7/48, H03K 7/08

(54) **Funktionen erzeugendes Ansteuerungsmodul für Leistungstransistoren**
Function generating drive module for power transistors
Module d'agencement avec génération de fonctions pour transistors de puissance

(30) Priorität: 15.09.1998 DE 19842141
(43) Veröffentlichungstag der Anmeldung: 22.03.2000
(73) Patentinhaber: WILO GmbH, 44236 Dortmund (DE)
(72) Erfinder: Waldemar, Stephan, 44319 Dortmund (DE)
(74) Vertreter: COHAUSZ DAWIDOWICZ HANNIG & PARTNER

(56) Entgegenhaltungen:
- DE-A- 4 015 854
- PATENT ABSTRACTS OF JAPAN vol. 018, no. 221 (E-1540), 20. April 1994 (1994-04-20) & JP 06 014593 A (MITSUBISHI ELECTRIC CORP), 21. Januar 1994 (1994-01-21)

## Beschreibung

Die Erfindung betrifft ein Verfahren zur Modulation der zeitliche Länge von Spannungspulsen, die insbesondere zur Ansteuerung von Leistungstransistoren dienen, wobei mittels eines Mikroprozessors ein Zwischenregister beschrieben und der Registerinhalt von einem Modul ausgelesen wird, wobei das Modul einen Spannungspuls initiiert und aufgrund des Registerinhaltes die Länge des Pulses festlegt. Die Erfindung betrifft gleichzeitig eine Steuerung zur Durchführung des Verfahrens.

Derartige Verfahren sind unter dem Begriff Pulsdauer- oder Pulsweitenmodulation (PWM) bekannt und werden zur Steuerung von Wechselstrommotoren eingesetzt. Beim Verfahren der Pulsweitenmodulation werden Leistungstransistoren von einer Steuereinheit für eine Pulsdauer auf Durchfluß geschaltet, so daß sich hinter den Leistungstransistoren eine entsprechend gepulste Versorgungsspannung an den Motorwicklungen ergibt. Da die Motorwicklungen aufgrund ihrer Induktivität die hochfrequente Wechselspannung glätten bzw. da sich vor den Motorwicklungen ein zusätzliches glättendes Filter befindet, fließt durch die Wicklungen ein Gleichstrom, bzw. liegt eine Gleichspannung an. Dieser Gleichstrom wird durch Modulation der Pulsweite in seiner Höhe variiert. Die Modulation der Pulsweite kann nunmehr derart erfolgen, daß in den Motorwicklungen ein Wechselstrom mit vergleichsweise niedriger Frequenz fließt.

Die technische Umsetzung der PWM geschieht so, daß ein Mikroprozessor eingesetzt wird, der einem Modul zur Erzeugung der Ansteuersignale der Leistungstransistoren (PWM-Modul) die Weite des nächsten zu erzeugenden Pulses als Wert in ein Register schreibt. Das PWM-Modul liest diesen Wert aus und schaltet den Leistungstransistor für eine dem Wert entsprechende Schaltzeit durch. Soll anhand solcher PWM-Werte eine Kurve insbesondere eine Wechselspannung erzeugt werden, so muß der Mikroprozessor für jede Schaltzeit ein Wert in das Register geschrieben werden. Dies geht jedoch mit einer großen Rechenleistung einher, so daß der Mikroprozessor schnell an die Grenze der Belastbarkeit gelangt. Sobald die Grenze überschritten und der Prozessor nicht mehr in der Lage ist, sein Register im richtigen Rhythmus neu zu setzen, entstehen in der Ausgabe des PWM-Moduls und damit in dem zu erzeugenden niederfrequenten Wechselstrom Diskontinuitäten. Diese führen zu elektromagnetischen Störungen, so daß ein erhöhter Filteraufwand notwendig ist.

Aufgabe der vorliegenden Erfindung ist es, ein Verfahren zur genannten Pulsweitenmodulation zu schaffen, mit dem sich bei geringem Rechneraufwand beliebige Pulsfolgen hoher Taktrate und damit glatte Stromkurven erzeugen lassen. Gleichzeitig ist es Aufgabe der Erfindung eine Elektronische Schalteinheit zur Durchführung des Verfahrens zu schaffen.

Diese Aufgabe wird durch ein Verfahren nach Anspruch 1 und eine Schalteinheit nach Anspruch 12 gelöst.

Der eigentliche Kern der Erfindung ist, daß dem PWM-Modul eine gewisse Intelligenz zugeordnet wird, mit der es aufgrund einiger vorgegebener Parameter, die es aus dem Register entnimmt, selbstständig die Weite des nächsten Pulses und damit Funktionen zur Modulation der Pulsweiten erzeugen kann. Dabei beinhaltet das PWM-Modul vorteilhafterweise einfachste Hardwarekomponenten wie Taktgeber oder Zähler, so daß eine große Pulsfrequenz und damit eine hohe Qualität der Modulation erreicht werden kann.

Besonderer Vorteil der Erfindung ist, daß das "intelligente" PWM-Modul den Mikroprozessor entlastet. Dieser kann sich nunmehr um andere Belange der Steuerung kümmern. Dabei kann die Kapazität des Mikroprozessors erheblich reduziert werden, was mit einer entsprechenden Minderung der Fertigungskosten der Steuerung einhergeht. Das erfindungsgemäße Verfahren läßt sich generell für alle Anwendungen der Pulsweitenmodulation einsetzen. Besonders vorteilhaft ist es jedoch, mit dem Verfahren Leistungstransistoren anzusteuern, die wie oben dargelegt eine Gleichspannung in den Wicklungen eines Elektromotors erzeugen, wobei diese Gleichspannung durch die erfindungsgeäße Modulation der Pulslängen zu einer für den Motor geeigneten niederfrequenten Wechselspannung umgewandelt wird.

Mit dem Einsatz der Erfindung zur Steuerung von Elektromotoren ist eine Glättung des die Motorwicklungen beaufschlagenden niederfrequenten Wechselstromes gegeben, so daß Gleichlaufschwankungen des Motors und elektromagnetische Störungen erheblich reduziert werden. Durch die möglichen Einsparungen im Filteraufwand ist eine weitere Kostensenkung gegeben. Dabei wird wegen der besonders einfachen Hardwarekomponenten die Wahrscheinlichkeit von Funktionsstörungen gemindert, so daß mit der Erfindung eine besonders zuverlässige Steuerung des Motors realisierbar ist. Vorteilhafterweise wird die Erfindung zur Steuerung eines Elektromotors einer drehzahlgeregelten Kreiselpumpe für Heizoder Kühlsysteme eingesetzt. Dabei zeichnen sich die erfindungsgemäß angesteuerten Pumpen durch besonders große Zuverlässigkeit und Flexibilität sowie durch besoders gute Laufeigenschaften aus.

Einerseits ist es vorteilhaft, PWM-Modul und Mikroprozessor als getrennte Hardwareeinheiten vorzusehen, um eine flexible Anpassung an verschiedene Gegebenheiten oder ein eventuelles Nachrüsten vorhandener Einheiten zu gewährleisten. Auf der anderen Seite kann es zur Vereinfachung der Steuerung und zur Reduzierung der Kosten beitragen, wenn der Mikroprozessor und das PWM-Modul eine gemeinsame Hardwareeinheit bilden, wobei der Mikroprozessor gleichzeitig ein PWM-Modul beinhaltet.

Vorteilhafterweise dient das Zwischenregister dazu, die nötigen Eckdaten, die zur Berechnung der Modulation notwendig sind, aufzunehmen. Diese können je nach Ausbildung des PWM-Moduls und je nach der Anforderung an die Modulationsfunktion unterschiedlich sein. In einer vorteilhaften Ausführungsform sind in das Register die Länge des ersten Startpulses, die Zahl der Pulse einer zu generierenden Pulsfolge und der funktionale Zusammenhang der Pulsweiten geschrieben, wobei der funktionale Zusammenhang im einfachsten Falle linear ist. Es ist jedoch vorteilhaft, dem PWM-Modul nicht die gesamte Modulation der niederfrequenten Wechselspannung zu übertragen, sondern die Modulationsfunktion in einzelne Abschnitte aufzuteilen und jeden der Abschnitte durch eine vom PWM-Modul generierte Teilfunktion anzunäheren. Dabei werden an den Ansetzpunkten vom Mikroprozessor jeweils neue Werte in das Register geschrieben. So kann das PWM-Modul im einfachsten Falle eine beliebige Modulationsfunktion, beispielsweise eine Sinusfunktion, durch einzelne gerade Teilfunktionen aproximieren.

Besonders vorteilhaft läßt sich eine Trapezfunktion generieren, da diese aus lauter geraden Teilstücken besteht und somit die Aproximation der zu generierenden Funktion entspricht. Wegen der hohen Taktfrequenz und wegen der großen Flexibilität des Modules bei der Erzeugung von Teilfunktionen können verschiedene Modulationsfunktionen beliebig genau aproximiert werden, ohne daß die CPU Rechenarbeit leisten muß.

In einer besonders vorteilhaften Ausführungsform des Verfahrens wird auch die Anzahl der Pulse in das Register geschrieben, die zwischen zwei sich in der Dauer ändernden Pulsen gleichbleibene Dauer aufweisen. Durch eine solche Folge von Pulsen gleichbleibender Länge wird bekanntermaßen für eine gewisse Zeit ein Gleichstrom in der angesteuerten Wicklung eines Motors erzeugt. An dieser Stelle sei angemerkt, daß die Begriffe "Pulsdauer", "Pulsweite" und "Pulslänge" synonym verwendet werden.

Eine zur Umsetzung des erfindungsgemäßen Verfahrens geeignete Schaltung und eine mit der Schaltung generierbare Modulationsfunktionen sind in den Zeichnungen 1 und 2 dargestellt und werden im folgenden näher beschrieben. Es zeigen
- **Figur 1**: eine Schaltung zur Pulsweitenmodulation,
- **Figur 2**: eine Pulsfolge mit zunehmender Pulsweite und
- **Figur 3**: eine angenäherte Modulationsfunktion.

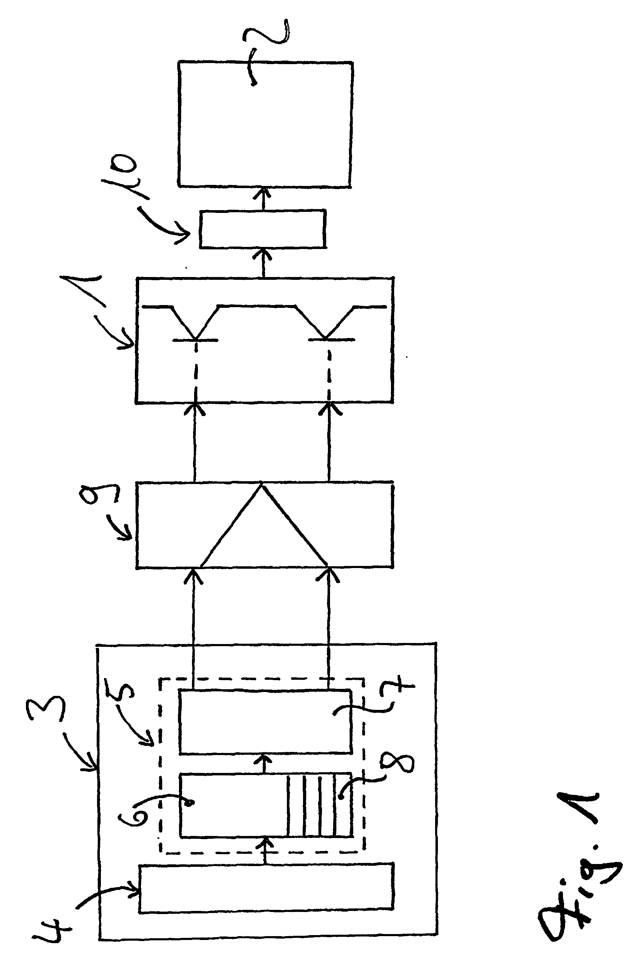

In Figur 1 ist eine elektronische Schalteinheit zur Steuerung eines Elektromotors dargestellt. Mit der Schaltung sind Spannungspulse einstellbarer zeitlicher Länge zur Ansteuerung von Leistungstransistoren 1 erzeugbar, die über einen Filter 10 einen Strom an die Motorwicklungen 2 durchschalten. Zur Ansteuerung der Transistoren 1 dient eine Recheneinheit 3, der ein Mikroprozessor mit zentraler Prozessoreinheit 4 (CPU) und ein Modul 5 zur Pulsweitenmodulation angehören, wobei CPU 4 und Modul 5 in diesem Ausführungsbeispiel zu einer physikalischen Einheit zusammengefaßt sind. Das Modul 5 weist seinerseits zwei getrennte Funktionseinheiten nämlich ein Steuerteil 6 und einen Modulationsteil 7 auf. Dem Steuerteil 6 ist ein Zwischenregister 8 zugeordnet, das zur Aufnahme mehrerer Werte ausgelegt ist und in welches die CPU 4 Daten einschreiben kann. Das Zwischenregister 8 ist gleichzeitig von dem Modul 5 auslesbar. Trotz der Vereinigung von Modul 5 und CPU 4 in einer gemeinsamen Schaltung stellt das Modul 5 für sich genommen eine eigenständige Recheneinheit dar, die zur Ausführung einfacher Operationen geeignet ist. So kann das Modul 5 über einen Treiber 9 Pulse bestimmter Dauer initiieren, mit denen die Leistungstransistoren 1 geschaltet werden.

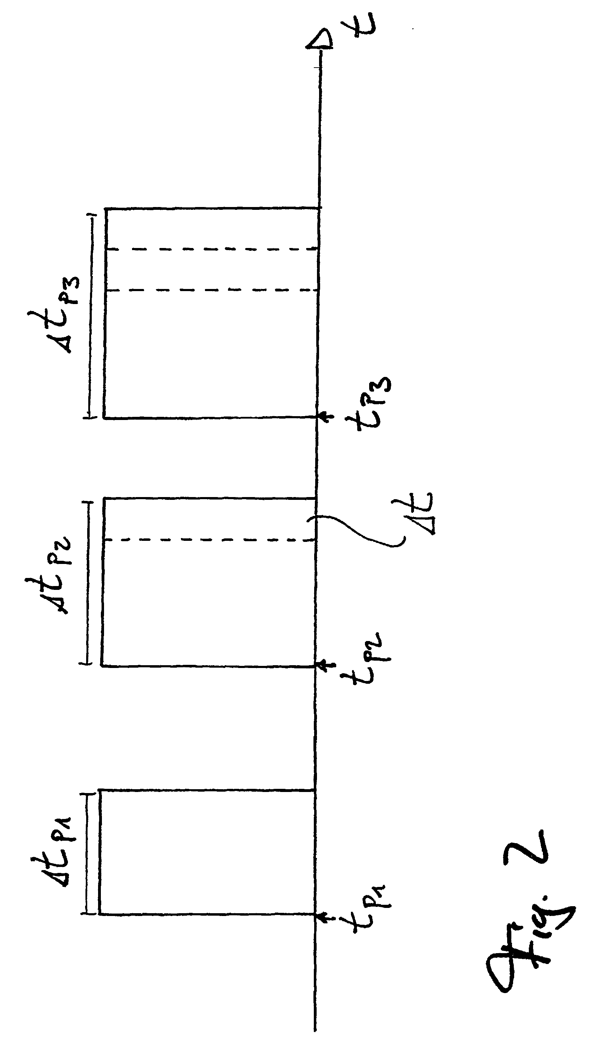

Eine solche vom Modul 5 generierte Pulsfolge ist in ihrer zeitlichen Abfolge in Figur 2 dargestellt. Zur Erzeugung der Pulsfolge werden zunächst von der CPU 4 Daten in den Zwischenspeicher geschrieben. Da es sich bei dem gezeigten Ausführungsbeispiel um eine lineare Zunahme der Pulsweite in der Zeit handelt, können die Daten die Länge Δt_{P1} des ersten Startpulses P1, die Zahl (hier drei) der zu generierenden Pulse bis zum Erreichen des letzten Endpulses P3 und der funktionale Zusammenhang der Länge der Folgepulse P2 und P3 beinhalten. Da der funktionale Zusammenhang in diesem Beispiel linear ist, wird als Längenänderungsfunktion ein Längenunterschied Δt = Δt_{Pn} - Δt_{Pn-1} von der CPU 4 in das Register geschrieben.

Sobald das Register beschrieben ist, hat das Modul 5 die Möglichkeit zum Zeitpunkt t_{P1} den Treiber 9 anzuregen, einen Startpuls der Länge Δt_{P1} zu generieren. Unabhängig von der CPU 4 berechnet das Modul, das in diesem einfachen Falle lediglich einen Taktgeber mit hoher Taktfrequenz, einen Zähler und ein Additionsglied aufweisen muß, die Länge des nachfolgenden Pulses Δt_{P2}. Eigenständig bestimmt das Modul den Zeitpunkt t_{P2}, an dem der nachfolgende Puls P2 generiert wird. Zur Erzeugung des Endpulses P3 braucht das Modul 5 nunmehr lediglich ein weiteres Δt auf die Pulslänge von Δt_{P2} zu addieren. Die Pulsfolge nach Figur 2 erzeugt somit in einer angeschlossenen Motorwicklung 2 eine innerhalb eines bestimmten Zeitraumes linear anwachsende Gleichspannung. Die mit der Pulsfolge generierte Funktion entspricht dabei einem Teil der Modulationsfunktion die der Strom in der Wicklung erzeugt.

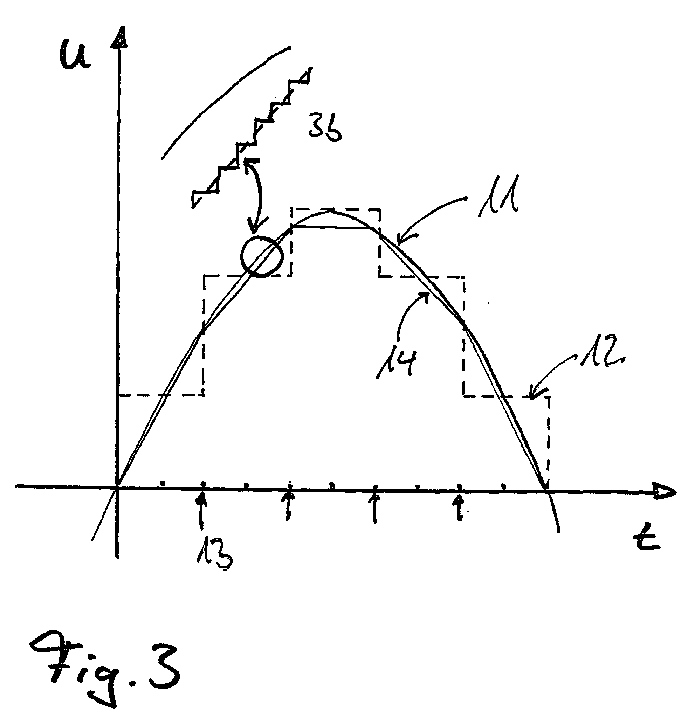

In Figur 3 ist eine Halbwelle der an einer Wicklung des Motors liegenden Wechselspannung gezeigt, wobei auf der Ordinate die Spannung U und auf der Abszisse die Zeit t aufgetragen ist. Die ideale Form der Modulationsfunktion 11 wird einmal mit einer bekannten Art der Pulsweitenmodulation angenähert(unterbrochene Linie 12). Deutlich zu erkennen sind die Stufen, die sich jeweils zu den Zeitpunkten des Prozessorzugriffes (Pfeile 13) von einem Niveaux zum nächsten erheben. Die Modulationsfunktion 13 wird gleichfalls durch das erfindungsgemäße Verfahren durch einzelne lineare Teilfunktionen 14 angenähert. Die Steigung der Teilfunktionen 14 wechselt jeweils bei einem Prozessorzugriff 13, bei dem die CPU neue Werte in das Zwischenregister schreibt. Zwischen zwei Prozessorzugriffen 13 wird die Teilfunktion durch das Modul 5 generiert. Die Abstufung der Teilfunktionen 14 ist wesentlich feiner, wie in dem Ausschnitt 3b zu erkennen ist.

## Patentansprüche

1. Verfahren zur Modulation der zeitlichen Länge von Spannungspulsen zur Ansteuerung von Leistungstransistoren (1), über die eine Spannung an eine Wicklung (2) eines elektronisch kommutierten Gleichstrommotors gelegt wird, wobei mittels eines Mikroprozessors (4) zunächst ein Zwischenregister (8) beschrieben wird und darauffolgend der Inhalt des Zwischenregisters von einem Modul (5) ausgelesen wird, und wobei das Modul die Länge des Spannungspulses entsprechend dem Registerinhalt festlegt und einen Spannungspuls initiiert,
**dadurch gekennzeichnet,**
- **daß** der Mikroprozessor (4) mehrere die Pulsfolge charakterisierende Daten in das Zwischenregister (8) schreibt,
- **daß** das Modul (5) die Daten aus dem Zwischenregister ausliest,
- **daß** das Modul (5) aufgrund der ausgelesenen Daten eigenständig eine Folge von mehreren Spannungspulsen veränderlicher Länge (P1, P2, P3) initiiert, wobei es die Länge des ersten Startpulses (P1) und die Veränderung der Länge der dem Startpuls folgenden Folgepulse bis zum Erreichen eines letzten Endpulses (P3) der Folge aus den Daten im Zwischenregister (8) berechnet.

2. Verfahren nach Anspruch 1,
**dadurch gekennzeichnet, daß** als Daten in das Zwischenregister (8) einerseits die Länge des Startpulses (P1), andererseits die Zahl der Pulse einer Pulsfolge und außerdem ein funktionaler Zusammenhang zwischen den Längen aufeinanderfolgender Pulse in Form einer Längenänderungsfunktion geschrieben werden.

3. Verfahren nach Anspruch 1 oder 2,
**dadurch gekennzeichnet, daß** in das Zwischenregister (8) die Länge des Startpulses (P1), die Länge des Endpulses (P3) und die Längenänderungsfunktion geschrieben werden und das Modul (5) das Erreichen des Endpulses (P3) durch Vergleich von aktueller Pulslänge und der vorgegebenen Länge des Endpulses (P3) erkennt.

4. Verfahren nach einem der vorherigen Ansprüche,
**dadurch gekennzeichnet, daß** die Längenänderungsfunktion eine lineare Funktion ist und in das Register (8) die Längenänderung ΔT von einem Puls zum darauffolgenden Puls geschrieben wird.

5. Verfahren nach einem der vorherigen Ansprüche,
**dadurch gekennzeichnet , daß** in das Register (8) die Anzahl der Pulse gleichbleibender Länge geschrieben wird.

6. Verfahren nach einem der vorherigen Ansprüche,
**dadurch gekennzeichnet, daß** das Modul (5) eine von dem Mikroprozessor (4) getrennte Hardwareeinheit in Form eines Zählermodules mit eigenem Taktgeber ist.

7. Verfahren nach einem der vorherigen Ansprüche,
**dadurch gekennzeichnet, daß** der Mikroprozessor (4) und das Modul (5) eine gemeinsame Hardwareeinheit (3) bilden.

8. Verfahren nach einem der vorherigen Ansprüche,
**dadurch gekennzeichnet, daß** über eine hochfrequente Pulsfolge Leistungstransistoren (1) angesteuert werden, die eine gefilterte Gleichspannung in einer Wicklung (2) eines Elektromotors erzeugen und daß die Gleichspannung durch die Modulation der Pulslängen zu einer für den Motor geeigneten niederfrequenten Wechselspannung umgewandelt wird, wobei die der Wechselspannung entsprechende Modulationsfunktion (11) vom Mikroprozessor oder einer Einheit zur Pulsweiten Modulation (PWM) generiert wird.

9. Verfahren nach Anspruch 8,
**dadurch gekennzeichnet, daß** die Modulationsfunktion (11) in einzelne Abschnitte aufgeteilt wird und daß jeder der Abschnitte durch eine Teilfunktion (14) angenähert wird.

10. Verfahren nach Anspruch 8 oder 9,
**dadurch gekennzeichnet, daß** die Modulationsfunktion (11) eine Trapetzfunktion ist, deren linearen Abschnitte durch lineare Teilfunktionen (14) beschrieben werden.

11. Verfahren nach einem der vorherigen Ansprüche,
**dadurch gekennzeichnet, daß** der Elektromotor zum Antrieb einer Kreiselpumpe insbesondere zur Versorgung eines Heizkreislaufes eingesetzt wird.

12. Elektronische Schalteinheit zur Steuerung eines elektronisch kommutierten Gleichstrommmotors, insbesondere zur Durchführung des Verfahrens nach einem der Ansprüche 1 bis 9, die Spannungspulse einstellbarer zeitlicher Länge zur Ansteuerung von Leistungstransistoren (1) erzeugt und die ein Zwischenregister (8) aufweist, das von einem Mikroprozessor (4) beschreibbar und von einem Modul (5) auslesbar ist, wobei der Inhalt des Zwischenregisters eine Information über die Länge des zu erzeugenden Pulses beinhaltet, und wobei mit dem Modul ein Spannungspuls initiierbar und in seiner Länge kontrollierbar ist,
**dadurch gekennzeichnet, daß** das Zwischenregister (8) zur Aufnahme mehrerer Werte ausgelegt ist und daß das Modul (5) eine vom Mikroprozessor (4) getrennte Schalteinheit ist, mit der anhand der ausgelesenen Daten des Zwischenregisters (8) eine Folge (P1, P2, P3) von in ihrer Länge variierender Steuerpulse initierbar ist.

13. Schalteinheit nach Anspruch 12,
**dadurch gekennzeichnet, daß** mit dem Modul (5) die individuelle Länge eines jeden Pulses aus einer beliebigen Anzahl aufeinanderfolgender Pulse unter Berücksichtigung der ausgelesenen Registerwerte selbstständig berechenbar ist.

14. Schalteinheit nach Anspruch 12 oder 13,
**dadurch gekennzeichnet, daß** das Modul (5) ein Zählermodul mit eigenem Taktgeber ist.

15. Verwendung der Schalteinheit nach den Ansprüchen 12 bis 14 zur Steuerung eines Elektromotors, der eine Kreiselpumpe in einem Heiz- oder Kühlkreislauf antreibt.

## Claims

1. A method of modulating the temporal length of voltage pulses for triggering power transistors (1) via which a voltage is applied to a winding (2) of an electronically commutated direct current motor, wherein an intermediate register (8) is first written to by means of a microprocessor (4) and thereafter the contents of the intermediate register are read out by a module (5), and wherein the module determines the length of the voltage pulse corresponding to the register contents and initiates a voltage pulse,
**characterised in that**
- the microprocessor (4) writes a plurality of data which characterise the pulse sequence to the intermediate register (8),
- that the module (5) reads out the data from the intermediate register,
- that based on the read-out data the module (5) independently initiates a sequence comprising a plurality of voltage pulses of variable length (P1, P2, P3), wherein it calculates, from the data in the intermediate register (8), the length of the first start pulse (P1) and the change in length of the sequential pulses which follow the start pulse until a final end pulse (P3) of the sequence is reached.

2. A method according to claim 1,
**characterised in that** firstly the length of the start pulse (P1), secondly the number of pulses of a pulse sequence, and, in addition, a functional relationship between the lengths of successive pulses in the form of a length change function, are written as data to the intermediate register (8).

3. A method according to claims 1 or 2,
**characterised in that** the length of the start pulse (P1), the length of the final pulse (P3) and the length change function are written to the intermediate register (8), and the module (5) identifies when the final pulse (P3) is reached by comparing the current pulse length with the predetermined length of the final pulse (P3).

4. A method according to any one of the preceding claims,
**characterised in that** the length change function is a linear function and that the length change ΔT from one pulse to the successive pulse is written to the register (8).

5. A method according to any one of the preceding claims,
**characterised in that** the number of pulses of constant length is written to the register (8).

6. A method according to any one of the preceding claims,
**characterised in that** the module (5) is a hardware unit which is separate from the microprocessor (4), in the form of a counter module comprising a separate clock generator.

7. A method according to any one of the preceding claims,
**characterised in that** the microprocessor (4) and the module (5) form a joint hardware unit (3).

8. A method according to any one of the preceding claims,
**characterised in that** power transistors (1), which generate a filtered, direct voltage in a winding (2) of an electric motor, are triggered via a high-frequency pulse sequence, and that the direct voltage is converted to a low-frequency alternating voltage suitable for the motor by modulating the pulse lengths, wherein the modulation function (11) which corresponds to the alternating voltage is generated by the microprocessor or by a unit for pulse width modulation (PWM).

9. A method according to claim 8,
**characterised in that** the modulation function (11) is subdivided into individual sections, and that each of the sections is approximated by a partial function (14).

10. A method according to claims 8 or 9,
**characterised in that** the modulation function (11) is a trapezium function, the linear sections of which are described by linear partial functions (14).

11. A method according to any one of the preceding claims,
**characterised in that** the electric motor is used for driving a centrifugal pump, particularly for supplying a heating circuit.

12. An electronic switching unit for controlling an electronically commutated direct current motor, particularly for carrying out the method according to any one of claims 1 to 9, which generates voltage pulses of adjustable temporal length for triggering power transistors (1) and which comprises an intermediate register (8) which can be written to by a microprocessor (4) and which can be read out by a module (5), wherein the contents of the intermediate register comprise information on the length of the pulse to be generated, and wherein a voltage pulse can be initiated and its length can be controlled by the module,
**characterised in that** the intermediate register (8) is designed for receiving a plurality of values, and that the module (5) is a switching unit which is separate from the microprocessor (4) and with which a sequence (P1, P2, P3) of control pulses of variable lengths can be initiated with the aid of the data which is read out from the intermediate register (8).

13. A switching unit to according to claim 12,
**characterised in that** the individual length of each pulse can be calculated independently by the module (5) from an arbitrary number of successive pulses, taking into consideration the read-out register values.

14. A switching unit according to claims 12 or 13,
**characterised in that** the module (5) is a counter module comprising a separate clock generator.

15. Use of a switching unit according to claims 12 to 14 for controlling an electric motor which drives a centrifugal pump in a heating or cooling circuit.

## Revendications

1. Procédé de modulation des longueurs dans le temps d'impulsions de tension pour l'excitation de transistors de puissance (1) par lesquels une tension est appliquée à un enroulement (2) d'un moteur à courant continu à commutation électronique, un registre intermédiaire (8) étant d'abord inscrit au moyen d'un microprocesseur (4) et le contenu du registre intermédiaire étant lu à la suite par un module (5) et le module déterminant la longueur de l'impulsion de tension en correspondance du contenu du registre et initiant une impulsion de tension,
**caractérisé en ce**
- **que** le microprocesseur (4) inscrit dans le registre intermédiaire (8) plusieurs données caractérisant le train d'impulsions,
- **que** le module (5) extrait les données du registre intermédiaire,
- **que** le module (5) initie de manière originale une succession de plusieurs impulsions de tension (P1, P2, P3) de longueur variable sur la base des données extraites, tout en comptant la longueur de la première impulsion de départ (P1) et la modification de la longueur de l'impulsion de la succession suivant l'impulsion de départ jusqu'à l'obtention d'une dernière impulsion de fin (P3) de la succession à partir des données dans le registre intermédiaire (8).

2. Procédé selon la revendication 1,
**caractérisé en ce que** d'une part la longueur de l'impulsion de départ (P1), d'autre part le nombre d'impulsions de la succession d'impulsions et en outre une relation fonctionnelle entre les longueurs d'impulsions successives sous forme d'une fonction de variation de longueur sont inscrits en tant que données dans le registre intermédiaire (8).

3. Procédé selon la revendication 1 ou 2,
**caractérisé en ce que** la longueur de l'impulsion de départ (P1), la longueur de l'impulsion de fin (P3) et la fonction de variation de longueur sont inscrites dans le registre intermédiaire (8) et le module (5) reconnaît l'obtention de l'impulsion de fin (P3) par comparaison de la longueur d'impulsion instantanée avec la longueur prédéfinie de l'impulsion de fin (P3).

4. Procédé selon l'une des revendications précédentes,
**caractérisé en ce que** la fonction de modification de longueur est une fonction linéaire et la modification de longueur ΔT d'une impulsion par rapport à l'impulsion suivante est inscrite dans le registre (8).

5. Procédé selon l'une des revendications précédentes,
**caractérisé en ce que** le nombre d'impulsions de longueur restant égale est inscrit dans le registre (8).

6. Procédé selon l'une des revendications précédentes,
**caractérisé en ce que** le module (5) est une unité de hardware séparée du microprocesseur (4) sous forme d'un module de compteur à horloge interne.

7. Procédé selon l'une des revendications précédentes,
**caractérisé en ce que** le microprocesseur (4) et le module (5) forment une unité de hardware (3) commune.

8. Procédé selon l'une des revendications précédentes,
**caractérisé en ce que**, par un train d'impulsions à haute fréquence, on amorce des transistors de puissance (1) qui engendrent une tension continue filtrée dans un enroulement (2) d'un moteur électrique et que la tension continue est convertie, par la modulation des longueurs d'impulsion, en une tension alternative à basse fréquence adaptée au moteur, la fonction de modulation (11) correspondant à la tension alternative étant générée par le microprocesseur ou une unité de modulation d'impulsions en largeur (PWM).

9. Procédé selon la revendication 8,
**caractérisé en ce que** la fonction de modulation (11) est divisée en sections individuelles et que chacune des sections est approchée par une fonction partielle (14).

10. Procédé selon la revendication 8 ou 9,
**caractérisé en ce que** la fonction de modulation (11) est une fonction trapézoïdale dont des sections linéaires sont décrites par des fonctions partielles (14) linéaires.

11. Procédé selon l'une des revendications précédentes,
**caractérisé en ce que** le moteur électrique est utilisé pour l'actionnement d'une pompe centrifuge en particulier pour l'alimentation d'un circuit de chauffage.

12. Unité de commutation électronique pour la commande d'un moteur à courant continu à commutation électronique, en particulier pour la mise en oeuvre du procédé selon l'une des revendications 1 à 9, qui engendre des impulsions de tension de longueur dans le temps réglable pour l'excitation de transistors de puissance (1) et qui présente un registre intermédiaire (8) qui peut être inscrit par un microprocesseur (4) et peut être extrait par un module (5), le contenu du registre intermédiaire contenant une information sur la longueur de l'impulsion à générer et une impulsion de tension pouvant, par le module, être initiée et être commandée pour sa longueur,
**caractérisée en ce que** le registre intermédiaire (8) est étudié pour recevoir plusieurs valeurs et que le module (5) est une unité de commutation séparée du microprocesseur (4) par laquelle, à partir des données extraites du registre intermédiaire (8), une succession (P1, P2, P3) d'impulsions de commande de longueur variable peut être initiée.

13. Unité de commutation selon la revendication 12,
**caractérisée en ce que**, par le module (5), la longueur individuelle de chacune des impulsions peut être calculée de manière originale à partir d'un nombre quelconque d'impulsions successives en prenant en compte les valeurs de registre extraites.

14. Unité de commutation selon la revendication 12 ou 13,
**caractérisée en ce que** le module (5) est un module de compteur à horloge interne.

15. Utilisation d'une unité de commutation selon l'une des revendications 12 à 14 pour la commande d'un moteur électrique qui entraîne une pompe centrifuge dans un circuit de chauffage ou de refroidissement.
